(19) **Europäisches Patentamt**
**European Patent Office**
**Office européen des brevets**

(11) **EP 2 711 800 B1**

(12) **EUROPEAN PATENT SPECIFICATION**

(45) Date of publication and mention of the grant of the patent:
**20.11.2019 Bulletin 2019/47**

(21) Application number: **12306155.8**

(22) Date of filing: **24.09.2012**

(51) Int Cl.:
*G05F 3/02* $^{(2006.01)}$      *G06F 17/50* $^{(2006.01)}$
*G11C 29/00* $^{(2006.01)}$      *G01R 29/02* $^{(2006.01)}$
*G01R 31/30* $^{(2006.01)}$      *H03K 19/003* $^{(2006.01)}$
*G11C 29/02* $^{(2006.01)}$

(54) **I/O cell calibration**

E/A-Zellkalibrierung

Étalonnage de cellules d'E/S

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.03.2014 Bulletin 2014/13**

(73) Proprietor: **Telefonaktiebolaget LM Ericsson (publ)**
**164 83 Stockholm (SE)**

(72) Inventors:
• **Locher, Matthias**
**06130 GRASSE (FR)**
• **Furet, Marc**
**06600 ANTIBES (FR)**

(74) Representative: **Grünecker Patent- und Rechtsanwälte**
**PartG mbB**
**Leopoldstraße 4**
**80802 München (DE)**

(56) References cited:
WO-A1-2012/059983    JP-A- 10 322 198
US-A1- 2003 093 233    US-A1- 2007 018 712
US-A1- 2007 018 713    US-A1- 2007 018 864
US-A1- 2008 103 634    US-A1- 2010 085 009
US-A1- 2011 029 266    US-B1- 6 233 190
US-B1- 7 138 824

## Description

### Technical Field

The proposed solution relates to the manufacture of Integrated Circuits (IC) such as microprocessors and, more particularly, to the calibration of input/output (I/O) cells used in such ICs.

It finds applications, in particular, in ICs for wireless devices such as mobile terminal systems (e.g. cell phones, smart phones, etc.), digital media players (e.g. MP3 and MP4 players), DVD player, portable PC, tablets, e-book readers, etc.

### Background Art

The approaches described in this section could be pursued, but are not necessarily approaches that have been previously conceived or pursued.

Therefore, unless otherwise indicated herein, the approaches described in this section are not prior art to the claims in this application and are not admitted to be prior art by inclusion in this section.

An I/O cell is an IC constituting element adapted to translate the voltage level of signals inputted and/or outputted by the IC to the voltage levels used in its outside environment within the electronic design.

An increasing number of ICs are manufactured using nanometers technologies.

Under this era of technologies, process, voltage and temperature (PVT) variability is becoming significantly important in affecting operation correctness and performances of the ICs.

For instance, I/O cells are among the elements of the IC which are most dependent on PVT variations.

Due to variable PVT operating conditions, the output signal strength and speed at output of the I/O cell of an IC varies widely, so that it is difficult to achieve best transmission conditions over external transmission lines.

To limit the resulting performance variation of an I/O cell, one may think of using a dedicated compensation cell on the IC that provides a code to the I/O cell.

Responsive to this code, the I/O cell may be configured such that it compensates for the PVT variations.

Therefore the compensation code may be used to compensate for any performance degradation at I/O cells of the IC caused by several factors, including but not limited to PVT operating conditions.

However, the semiconductor area required for such a dedicated compensation cell is not negligible.

For instance, it can increase the IC area by around 0.05 mm2 in CMOS 40 nm technology, thus leading to making electronic devices based on such IC more expensive.

Prior art document US7,138,824 discloses an integrated circuit including a gate-drive circuit coupled to a first I/O pad, a voltage-sensing circuit coupled to a second I/O pad, a current-sensing circuit coupled to the second I/O pad and a third I/O pad and a temperature sensing circuit coupled to a fourth I/O pad.

Prior art document US2011/0029266 discloses an integrated circuit including a process sensor, a temperature sensor and a voltage sensor. The output of the process sensor is coupled to at least one of the temperature sensor and the voltage sensor to compensate at least one of the indication of the temperature and the indication of the power supply voltage level.

### Summary of invention

This drawback may be overcome by compensating for I/O cell PVT variations without any dedicated compensation cell at all.

Indeed, the compensation code may be calculated without a dedicated compensation cell by using means of determining PVT variations which, as a matter of fact, are already available on the IC.

According to a first aspect there is proposed a method of determining a compensation code for an Input/Output, I/O, cell of an Integrated chip, IC, as recited in claim 1.

A second aspect relates to a processor for determining a compensation code for an Input/Output, IO, cell of an integrated chip, IC, as recited in claim 8.

Thus, in an integrated circuit embodying the principles of such mechanism, no important semiconductor area is required for the use of a dedicated compensation cell. PVT variation compensation is achieved by doing away with the dedicated compensation cell and thus using some means already available on the IC to perform the same task.

This helps reducing the cost of an IC using such mechanism.

Furthermore, this mechanism also brings flexibility since an optimisation of the tuning of the compensation code calculation could be done by just implementing a new formula for combining the elementary compensation codes.

In one embodiment, the first elementary compensation code may be determined as a function of previously measured process dependent currents at the output of the I/O cell.

This could be easily performed at the end of IC manufacturing process, for instance by using an adequately programmed ATE (Automatic Test Equipment).

In accordance with the proposed solution, the measurement of the voltage at the output of the I/O cell is triggered by a first predefined timer or after a voltage change from a nominal voltage has been detected.

Thus both static and dynamic behaviour of the IC is accounted for, which may be required in some applications.

Similarly, the measurement of the temperature of the IC may be triggered by a second predefined timer or after a temperature change from a nominal temperature has been detected.

In another embodiment, the compensation code may be equal to the sum of the first elementary compensation code, the second elementary compensation code and the third elementary compensation code.

This simple calculation is easy to implement and provides satisfying results when it can be assumed that PVT variation factors are independent one from each other, which is usually the case in practise. Some weighting factors, respectively associated with the elementary compensation codes, may also be used to refine the overall I/O cell compensation.

If necessary, the measurement of the voltage at the output of the I/O cell can be performed by using an ADC (Analog-to-Digital Converter).

ADC is often available at the baseband domain of the IC, such that it can be used to measure I/O cell power supply voltage, for instance.

In accordance with an embodiment of the proposed solution, the measurement of the temperature of the IC may be performed by a temperature sensor. The temperature sensor might be connected to an ADC.

Such embodiment relies on the capability of an ADC of converting the output voltage of a temperature sensor.

**Brief description of drawings**

A more complete understanding of the proposed solution may be obtained from a consideration of the following description in conjunction with the appended drawings, in which:

FIG. 1 is a circuit block diagram illustrating an example of implementation of the proposed solution.
FIG. 2 is a circuit block diagram illustrating an exemplary implementation of the proposed solution.
FIG. 3 is a block diagram illustrating an example of implementation of an output I/O cell.
FIG. 4 is a flow diagram illustrating embodiments of the proposed method.

**Description of embodiments**

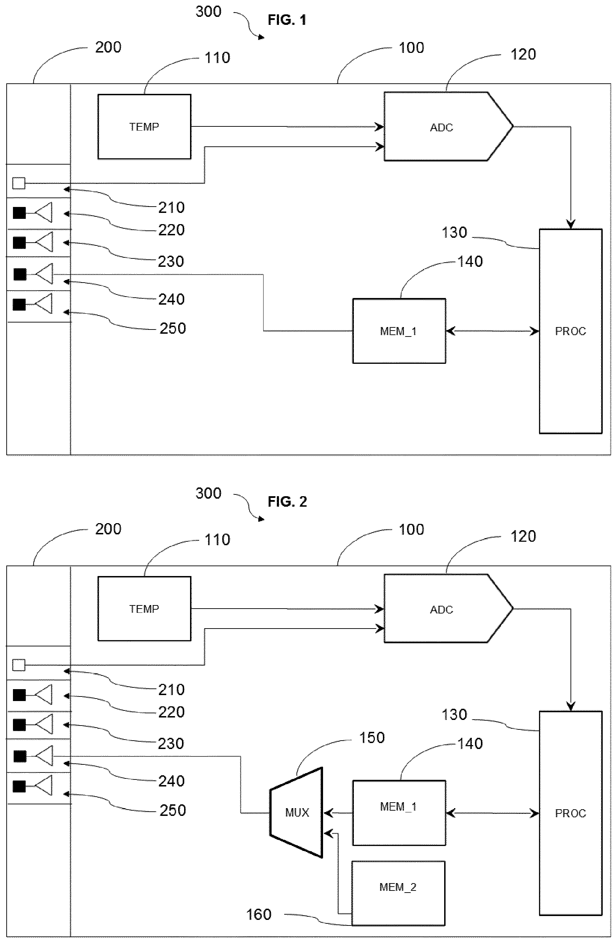

FIG. 1 is a circuit block diagram which schematically illustrates an example of implementation of the proposed solution.

Referring to FIG. 1, there is shown therein an integrated circuit (IC) 300 comprising two parts, a core part 100 and a periphery part 200.

In the shown example, the core part 100 comprises a temperature sensor 110, an Analog-to-Digital converter (ADC) 120, a processor 130, and a memory cell 140.

The temperature sensor may be configured to sense the IC temperature and to provide a corresponding temperature sensing signal to the input of the ADC 120.

The ADC 120 may be configured to convert the output voltage of the temperature sensor 110 into a digital code, referred to as an elementary compensation code herein, and it is also configured to provide that digital code to the processor 130 for further processing.

The processor 130 is also configured to read or write the memory cell 140. The memory cell 140 may be an on-chip memory register such as an EPROM or the like.

The periphery part 200 of the IC 300 comprises a power supply cell 210 and a plurality of I/O cells, for instance 220, 230, 240 or 250.

The power supply cell 210 is configured to supply the I/O cells in power.

The plurality of I/O cells aim at providing for signal transmission between the core 100 of the IC 300 and its external environment, namely the circuit board package where the IC 300 is secured onto or the System-on-Chip (Soc) containing the IC.

Providing for high speed of data transmission at the output of I/O cell 220, 230, 240 or 250 level requires providing a minimum variation of transition time (i.e. rise and fall times) over PVT operating conditions.

Indeed, any decrease in transition time variation depending on PVT variations can usually be translated into better timing budgets and signal integrity, resulting in the increase of the operating speed of the I/O cell.

To achieve good signal integrity, the transition time must be kept constant over a wide range of PVT variations.

One method to improve I/O cell speed is to provide for a compensation of such PVT variations.

Such compensation effect is achieved by a code that is applied at the input of one or more of the I/O cells 220, 230, 240 and/or 250 such that the slower I/O cell can be speeded up or the faster I/O cell can be slowed down to match a nominal or typical performance.

The nominal performance may correspond to a set of characteristics, such as voltage or temperature, which are defined at the design of an I/O cell in order to obtain particular overall performance of the entire IC.

The proposed method of determining the compensation code to be applied at the input of an I/O cell such as cells 220, 230, 240, and 250 relies on the usage of block components commonly present in, for instance, mobile communication circuits.

With reference to Figure 1, these components include, for instance, an ADC 120, a temperature sensor 110, a memory cell 140 and a processor 130.

Therefore, it is proposed to do away with an alternative practice consisting in using a dedicated compensation cell (not shown), thus sparing some semiconductor area on the IC 300.

A first elementary compensation code may account for process variations. It may be stored in a memory associated with the IC 300 such as an on-chip memory cell 140.

Such memory may also be external to the IC. In both case, one and the same memory may be used for storing one elementary compensation code for all I/O cells.

This is suitable for application where only one type of I/O cell is used, namely I/O cells of same technology and design.

However, a configuration where such memory cell 140 is dedicated for storing respective first elementary compensation codes for each I/O cell such as 220, 230, 240 and 250 cells can also be considered.

The compensation code may have been previously determined either by simulation or by silicon measurement.

For instance, if the IC 300 is based on CMOS technology having PMOS and NMOS elements, the Precision Measurement Unit (PMU) existing within an Automatic Test Equipment (ATE) may be used to measure PMOS and NMOS currents at the output of the various I/O cells.

The compensation code at the input of the I/O cell would then be varied until the measured PMOS and NMOS match the required nominal currents for the I/O cell under a nominal or typical PVT condition.

Finally, the resulting value of the first elementary compensation code can be stored in the memory cell 140.

For all further embodiments, it will be assumed that CMOS technology is used. However, the proposed solution may be embodied using other fabrication processes, for instance bipolar or bi-CMOS technology.

A second elementary compensation code for voltage variations may be further determined based, for instance, on a previously determined function and on at least one measured voltage such as the output voltage of an I/O cell among cells 220, 230, 240 and 250.

The ADC 120 available on the IC 300 may be selectively connected to the node VDD of the power supply cell 210, for instance by means of switches.

The ADC 120 may thus receive an analog voltage from the power supply cell 210 and convert the analog voltage value corresponding to the measured voltage, to a digital voltage value (i.e. a bit code).

The digital voltage value may then be transmitted to the processor 130.

The aforementioned previously determined function may be a linear function or a non-linear function, depending on the trade-off between accuracy and complexity required by the application.

A third elementary compensation code for temperature variations may finally be determined based on a previously determined function and at least a measured temperature of the IC 300.

The ADC 120 available on the IC 300 may be connected to the temperature sensor 110.

The temperature 110 may be configured to sense the IC 300 temperature and also to provide a signal representative of the sensed temperature in the form of an analog voltage, to the ADC 120.

The ADC 120 may thus receive the analog voltage from the temperature sensor 110 and convert the analog temperature value, corresponding to the sensed temperature, to a digital temperature value (i.e. a bit code).

The digital temperature value may then be transmitted to the processor 130.

The aforementioned previously determined function may be a linear function or a non-linear function, depending on the trade-off between accuracy and complexity required by the application.

Knowing the elementary compensation codes for process variations, voltage variations and temperature variations, respectively, there can be determined an overall compensation code that can be applied at input of at least some of the I/O cells 220, 230, 240 and 250.

It will be appreciated that process variations, voltage variations and temperature variations mainly occur at different moments in time.

This means that they are independent one form the others.

Thus, it is possible to determine the overall compensation by simply summing all foregoing compensation codes.

For instance, overall compensation code may be obtained from the following formula (1):

$$OverallCompensationCode = INT \left( CompensationCodeForProcess \right.$$
$$+ INT \left( CompensationCodeForVoltage \right) +$$
$$INT \left( CompensationCodeForTemperature \right) \qquad (1)$$

It will be noted by the one with ordinary skills in the art that in above formula (1) the operator "INT" is used for rounding its parameter to the nearest integer. In fact, parameters used in the different previously determined function such as temperature or voltage may be signed values, and may be non integer. Therefore, operator "INT" may be used to ensure that *OverallCompensationCode* is an integer, thus enabling easier calculation. However, such rounding is not compulsory.

It is also noteworthy that *OverallCompensationCode* may not be applied directly at the input of an I/O cell 220, 230, 240 or 250 all the time.

In fact, *OverallCompensationCode* corresponds to the compensation code that is applied at the input of at least one of these I/O cells in case of PVT variations only.

However, even when there are no PVT variations, a nominal compensation code may be applied on the input of an I/O cell 220, 230, 240 or 250.

For instance, such nominal compensation code might correspond to the compensation code that is applied at all time at the input of an I/O cell such that best performance is experienced under a nominal or typical PVT condition.

In this case, when PVT variations are experienced on the IC 300 the nominal compensation code of the typical PVT condition might not perform well on the I/O cell since the current PVT condition might differ from the nominal or typical PVT condition.

Based on this assertion, it is meant that *OverallCompensationCode* is a "delta" code to the nominal compensation code used to adjust the nominal compensation code such that best performance is experienced by an I/O cell 220, 230, 240, 250 in case of any PVT variations.

To summarize, the composite compensation code that is applied at the input of an I/O cell 220, 230, 240 or 250 may be obtained from the following formula (2):

$$CompositeCode = NominalCompensationCode + OverallCompensationCode \qquad (2)$$

FIG. 2 is a circuit block diagram which schematically illustrates an exemplary implementation of the proposed solution.

Referring to FIG. 2, there is shown therein the IC 300 of FIG. 1 with the same components as already described above, with the addition of a second memory cell 160 and a multiplexer 150.

The memory cell 140 and the second memory cell 160 are both connected to the input of the multiplexer 150.

The output of the multiplexer 150 is connected to the input of an I/O cell 220, 230, 240 and/or 250.

In the shown embodiment, the second memory cell 160 might be a one-time programmable (OTP) memory.

The usage of an OTP 160 could be considered to store the first elementary compensation code corresponding to compensation of process variations, since it may have been previously calculated and given that no recalculation should be required during the lifetime of the IC.

Thus, compensation code for process variations can be stored on an OTP 160 for easier access.

This configuration could also be interesting for certain application that could take advantage of the access speed of an OTP 160 over a memory cell 140.

In fact, an OTP 160 can be accessible to an I/O cell 220, 230, 240 and 250 even before the device containing the IC 300 has completely started, such that compensation code contained in the OTP 160 may be applied to the I/O cell 220, 230, 240 and 250 right at the start of the device, thus enabling the best performance from the start.

This would not be the case for a memory cell 140 since it requires the processor 130 to be up and running prior its usage.

Therefore, with the embodiment of FIG. 2, applications that need to benefit from best I/O cell 220, 230, 240 and 250 performance from the start can be supported.

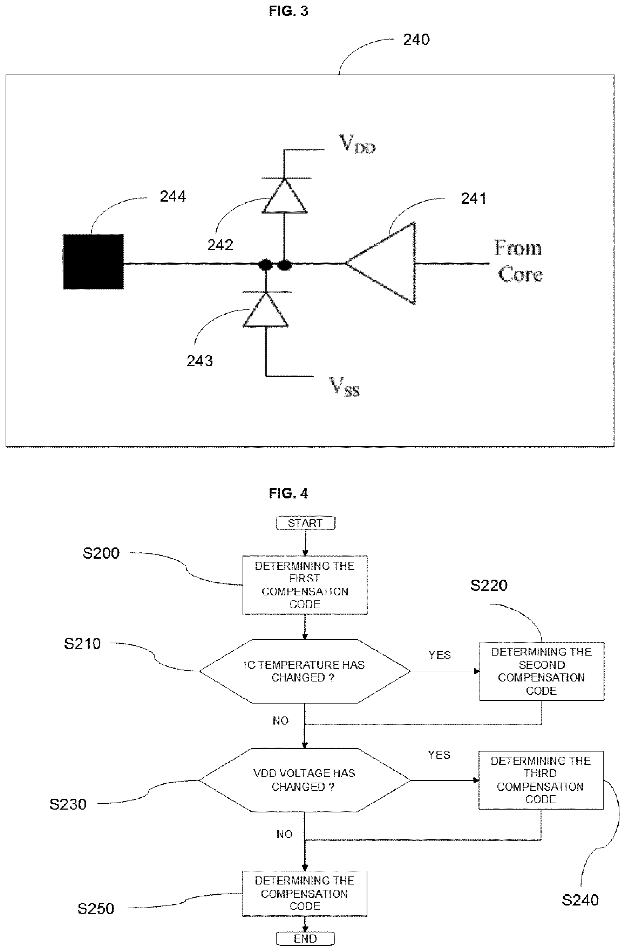

FIG. 3 is a block diagram which schematically illustrates an example of implementation of an output I/O cell 220, 230, 240 or 250.

Referring to FIG. 3, there is shown therein the I/O cells of FIGs. 1 and 2 comprising, for instance, a buffer 241, two diodes 242 and 243 and a pad 244.

The buffer 241 is configure to amplify the signal receive from the core of the IC 300.

For instance, referring to FIG. 1, the signal is received from the memory cell 140 while in FIG. 2, the signal is received from the multiplexer 150.

In the proposed solution, the received signal corresponds to the *CompositeCode* as defined earlier.

Then, the signal is driven thanks to the power supply characterised by VSS and VDD through the two diodes 242 and 243.

It will be noted that VSS and VDD are sometimes called VSSIO and VDDIO in the literature, when the power supply is providing for an I/O cell 220, 230, 240 or 250 in order to distinguish it from the power supply providing for the IC 300.

In one embodiment of the proposed solution, the compensation code for process variations is calculated by the processor 130.

In fact, process dependent currents previously measured by the PMU inside the ATE can be correlated to on chip process monitor blocks.

Therefore, the compensation code for process variations can be determined by a previously determined function based on previously measured process dependent currents.

It will be noted by the one with ordinary skills in the art, that measurements of positive and negative currents are made at the output of the buffer 241 of an I/O cell 220, 230, 240 or 250.

The previously determined function may be a linear function or not, depending on the trade-off between accuracy and complexity required by the application.

In another embodiment, the measurement of an output voltage of an I/O cell 220, 230, 240 or 250 is triggered at fixed period based on predetermined timer.

Alternatively, the measurement might be dynamic by being triggered only when a voltage change from a nominal voltage has been detected, for instance by the processor 130.

It will be noted by the one with ordinary skills in the art, that nominal voltage value might be located on the processor 130 or elsewhere on the IC 300.

In yet another embodiment, the measurement of the temperature of the IC 300 may be triggered at fixed period based on predetermined timer.

Alternatively, the measurement might be dynamic by being triggered only when a temperature change from a nominal temperature has been detected, for instance by the processor 130.

It will be noted by the one with ordinary skills in the art, that nominal temperature value might be located on the processor 130 or elsewhere on the IC 300.

FIG. 4 is a flow diagram illustrating embodiments of the proposed method consistent with the embodiment of the proposed solution already described above with FIGs. 1 and 2.

Depending on the embodiment, additional steps may be added, others removed, and the ordering of the steps rearranged.

Referring to FIG. 4, in step S200, the first elementary compensation code is determined as previously explained for compensation of process variations.

In step S210, it is tested whether IC 300 temperature has changed.

As explained earlier as well, this test could be performed at predefined moment in time or dynamically at the reception of an event change corresponding to a temperature change from a nominal temperature of the I/O cell 220, 230, 240 or 250.

If, the temperature of the IC has changed, in step 220 a second elementary compensation code is determined for compensation of temperature variations.

After, step S210 and step S220, in step S230 it is tested whether I/O cell 220, 230, 240 or 250 output voltage has changed.

As explained earlier as well, this test could be performed at predefined moment in time or dynamically at the reception of an event change corresponding to a voltage change from a nominal voltage of the I/O cell 220, 230, 240 or 250.

If, the voltage of the I/O cell 220, 230, 240 or 250 has changed, in step 240 a third elementary compensation code is determined for compensation of voltage variations.

After step S230 and step S240 a compensation code corresponding to the *OverallCompensationCode* as already explained above is determined in step S250.

After that, the algorithm would stop.

In another aspect of the proposed solution, a processor 130 for determining the compensation code to be applied at the input of an I/O cell 220, 230, 240 or 250 is proposed.

The processor 130 may implement features such as those already described in FIGs. 1 and 2.

Namely, the processor 130 is configured to compute the *OverallCompensationCode* based on, at least, input information gathered from the ADC 120, the temperature sensor 110 and/or process related information.

In the claims, the word "comprising" does not exclude other elements or steps, and the indefinite article "a" or "an" does not exclude a plurality. A single unit may fulfil the functions of several items recited in the claims. The mere fact that different features are recited in mutually different dependent claims does not indicate that a combination of these features cannot be advantageously used. Any reference signs in the claims should not be construed as limiting the scope of the proposed solution.

**Claims**

1. A method of determining a compensation code for an Input/Output, IO, cell (220, 230, 240, 250) of an integrated chip, IC, (300), the IO cell comprising its own power supply, the method comprising:

    - obtaining a first elementary compensation code from a memory cell (140) associated with the IC, the first elementary compensation code accounting for process variations of the IC and being based, at least, on an information representative of Process, Voltage and Temperature, PVT, operating conditions of the IC;

    In response to a variation of the PVT operating conditions:

    - measuring an output voltage of the I/O cell under the PVT operating conditions and determining a second elementary compensation code as a function of at least the measured output voltage, the second compensation code accounting for voltage variations of the I/O cell;
    - measuring a temperature of the IC under the PVT operating conditions and determining a third elementary compensation code as a function of at least the measured temperature, the third compensation code accounting for temperature variations of the IC; and,
    - determining the compensation code as a function of at least the first elementary compensation code, the second elementary compensation code and the third elementary compensation code.

2. The method of claim 1, wherein the first elementary compensation code is determined as a function of previously measured process dependent currents at the output of the I/O cell.

3. The method of any one of claims 1 to 2, wherein measuring an output voltage of the I/O cell is triggered by a first predefined timer or after a voltage change from a nominal voltage has been detected.

4. The method of any one of claims 1 to 3, wherein measuring a temperature of the IC is triggered by a second predefined timer or after a temperature change from a nominal temperature has been detected.

5. The method of claims 2 to 4, wherein the compensation code is equal to the sum of the first elementary compensation code, the second elementary compensation code and the third elementary compensation code.

6. The method of any one of claims 1 to 5, wherein measuring an output voltage of the I/O cell is performed by an ADC (Analog-to-Digital Converter) (120).

7. The method of any one of claims 1 to 6, wherein measuring a temperature of the IC is performed by a temperature sensor (110).

8. A processor (130) for determining a compensation code for an Input/Output, IO, cell (220, 230, 240, 250) of an integrated chip, IC, (300), the IO cell comprising its own power supply, the processor comprising:

    - a unit configured to obtain a first elementary compensation code from a memory cell (140) associated with the IC, the first elementary compensation code accounting for process variations of the IC and based, at least, on an information representative of Process, Voltage and Temperature, PVT, operating conditions of the IC;
    - a unit configured to measure an output voltage of the I/O cell under the PVT operating conditions and determining a second elementary compensation code as a function of at least the measured output voltage in response to a variation of the PVT operating conditions, the second compensation code accounting for voltage variations of the I/O cell;
    - a unit configured to measure a temperature of the IC under the PVT operating conditions and determine a third elementary compensation code as a function of at least the measured temperature in response to a variation of the PVT operating conditions, the third compensation code accounting for temperature variations of the IC; and,
    - a unit configured to determine the compensation code as a function of at least the first elementary compensation code, the second elementary compensation code and the third elementary compensation code.

9. The processor of claim 8, further configured to determine the first elementary compensation code as a function of previously measured process dependent currents at the output of the I/O cell.

10. The processor of any one of claims 8 to 9, further configured to measure an output voltage of the I/O cell in response to the triggering of a first predefined timer or after a voltage change from a nominal voltage has been detected.

11. The processor of any one of claims 8 to 10, further configured to measure a temperature of the IC in response to the triggering of a second predefined timer or after a temperature change from a nominal temperature has been detected.

12. The processor of claims 9 to 11, wherein the compensation code is equal to the sum of the first elementary compensation code, the second elementary compensation code and the third elementary compensation code.

13. The processor of any one of claims 8 to 12, wherein an ADC (Analog-to-Digital Converter) (120) measures an input voltage for the IO by.

14. The processor of any one of claims 8 to 13, wherein a temperature sensor (110) measures a temperature of the IC .

**Patentansprüche**

1. Verfahren zum Bestimmen eines Kompensationscodes für eine Eingang/Ausgang (E/A)-Zelle (220, 230, 240, 250) eines integrierten Chips (IC) (300), wobei die E/A-Zelle ihre eigene Stromversorgung aufweist, wobei das Verfahren umfasst:

   - Erhalten eines ersten elementaren Kompensationscodes von einer Speicherzelle (140), die mit dem IC assoziiert ist, wobei der erste elementare Kompensationscode Prozessvariationen des IC berücksichtigt und wenigstens teilweise auf Informationen zu den Prozess-, Spannungs- und Temperatur- (PVT)-Betriebsbedingungen des IC basiert,

   in Reaktion auf eine Variation der PVT-Betriebsbedingungen:

   - Messen der Ausgangsspannung der E/A-Zelle unter den PVT-Betriebsbedingungen und Bestimmen eines zweiten elementaren Kompensationscodes in Abhängigkeit von wenigstens der gemessenen Ausgangsspannung, wobei der zweite Kompensationscode Spannungsvariationen der E/A-Zelle berücksichtigt,
   - Messen der Temperatur des IC unter den PVT-Betriebsbedingungen und Bestimmen eines dritten elementaren Kompensationscodes in Abhängigkeit von wenigstens der gemessenen Temperatur, wobei der dritte Kompensationscode Temperaturvariationen des IC berücksichtigt, und
   - Bestimmen des Kompensationscodes in Abhängigkeit von wenigstens dem ersten elementaren Kompensationscode, dem zweiten elementaren Kompensationscode und dem dritten elementaren Kompensationscode.

2. Verfahren nach Anspruch 1, wobei der erste elementare Kompensationscode in Abhängigkeit von zuvor gemessenen, prozessabhängigen Strömen am Ausgang der E/A-Zelle bestimmt wird.

3. Verfahren nach einem der Ansprüche 1 bis 2, wobei das Messen der Ausgangsspannung der E/A-Zelle durch einen ersten vordefinierten Timer ausgelöst wird oder nach dem Erfassen einer Spannungsänderung von einer Nennspannung erfolgt.

4. Verfahren nach einem der Ansprüche 1 bis 3, wobei das Messen der Temperatur des IC durch einen zweiten vordefinierten Timer ausgelöst wird oder nach dem Erfassen einer Temperaturänderung von einer Nenntemperatur erfolgt.

5. Verfahren nach einem der Ansprüche 2 bis 4, wobei der Kompensationscode gleich der Summe aus dem ersten elementaren Kompensationscode, dem zweiten elementaren Kompensationscode und dem dritten elementaren Kompensationscode ist.

6. Verfahren nach einem der Ansprüche 1 bis 5, wobei das Messen der Ausgangsspannung der E/A-Zelle durch einen ADW (Analog-Digital-Wandler) (120) durchgeführt wird.

**7.** Verfahren nach einem der Ansprüche 1 bis 6, wobei das Messen der Temperatur des IC durch einen Temperatursensor (110) durchgeführt wird.

**8.** Prozessor (130) zum Bestimmen eines Kompensationscodes für eine Eingang/Ausgang (E/A)-Zelle (220, 230, 240, 250) eines integrierten Chips (IC) (300), wobei die E/A-Zelle ihre eigene Stromversorgung aufweist, wobei der Prozessor umfasst:

- eine Einheit, die konfiguriert ist zum Erhalten eines ersten elementaren Kompensationscodes von einer Speicherzelle (140), die mit dem IC assoziiert ist, wobei der erste elementare Kompensationscode Prozessvariationen des IC berücksichtigt und wenigstens teilweise auf Informationen zu den Prozess-, Spannungs- und Temperatur- (PVT)-Betriebsbedingungen des IC basiert,
- eine Einheit, die konfiguriert ist zum Messen der Ausgangsspannung der E/A-Zelle unter den PVT-Betriebsbedingungen und zum Bestimmen eines zweiten elementaren Kompensationscodes in Abhängigkeit von wenigstens der gemessenen Ausgangsspannung in Reaktion auf eine Variation der PVT-Betriebsbedingungen, wobei der zweite Kompensationscode Spannungsvariationen der E/A-Zelle berücksichtigt,
- eine Einheit, die konfiguriert ist zum Messen der Temperatur des IC unter den PVT-Betriebsbedingungen und zum Bestimmen eines dritten elementaren Kompensationscodes in Abhängigkeit von wenigstens der gemessenen Temperatur in Reaktion auf eine Variation der PVT-Betriebsbedingungen, wobei der dritte Kompensationscode Temperaturvariationen des IC berücksichtigt, und
- eine Einheit, die konfiguriert ist zum Bestimmen des Kompensationscodes in Abhängigkeit von wenigstens dem ersten elementaren Kompensationscode, dem zweiten elementaren Kompensationscode und dem dritten elementaren Kompensationscode.

**9.** Prozessor nach Anspruch 8, der weiterhin konfiguriert ist zum Bestimmen des ersten elementaren Kompensationscodes in Abhängigkeit von zuvor gemessenen, prozessabhängigen Strömen am Ausgang der E/A-Zelle.

**10.** Prozessor nach einem der Ansprüche 8 und 9, der weiterhin konfiguriert ist zum Messen der Ausgangsspannung der E/A-Zelle in Reaktion auf das Auslösen eines ersten vordefinierten Timers oder nach dem Erfassen einer Spannungsänderung von einer Nennspannung.

**11.** Prozessor nach einem der Ansprüche 8 bis 10, der weiterhin konfiguriert ist zum Messen der Temperatur des IC in Reaktion auf das Auslösen eines zweiten vordefinierten Timers oder nach dem Erfassen einer Temperaturänderung von einer Nenntemperatur.

**12.** Prozessor nach einem der Ansprüche 9 bis 11, wobei der Kompensationscode gleich der Summe aus dem ersten elementaren Kompensationscode, dem zweiten elementaren Kompensationscode und dem dritten elementaren Kompensationscode ist.

**13.** Prozessor nach einem der Ansprüche 8 bis 12, wobei ein ADW (Analog-Digital-Wandler) (120) die Eingangsspannung für die E/A-Zelle misst.

**14.** Prozessor nach einem der Ansprüche 8 bis 13, wobei ein Temperatursensor (110) die Temperatur des IC misst.

**Revendications**

**1.** Procédé de détermination d'un code de compensation pour une cellule d'Entrée/Sortie, IO, (220, 230, 240, 250) d'une puce intégrée, IC, (300), la cellule IO comprenant sa propre alimentation électrique, le procédé comprenant de :

- obtenir un premier code de compensation élémentaire à partir d'une cellule de mémoire (140) associée à la IC, le premier code de compensation élémentaire tenant compte de variations de processus de la IC et étant basé, au moins, sur une information représentative des conditions de fonctionnement de Processus, Tension et Température, PVT, de la IC ;

en réponse à une variation des conditions de fonctionnement PVT :

- mesurer une tension de sortie de la cellule I/O dans les conditions de fonctionnement PVT et déterminer un deuxième code de compensation élémentaire en fonction au moins de la tension de sortie mesurée, le deuxième code de compensation tenant compte de variations de tension de la cellule I/O ;
- mesurer une température de la IC dans les conditions de fonctionnement PVT et déterminer un troisième code de compensation élémentaire en fonction au moins de la température mesurée, le troisième code de compensation tenant compte de variations de température de la IC ; et,
- déterminer le code de compensation en fonction au moins du premier code de compensation élémentaire, du deuxième code de compensation élémentaire et du troisième code de compensation élémentaire.

2. Procédé selon la revendication 1, dans lequel le premier code de compensation élémentaire est déterminé en fonction de courants dépendants du processus précédemment mesurés à la sortie de la cellule I/O.

3. Procédé selon l'une quelconque des revendications 1 à 2, dans lequel la mesure d'une tension de sortie de la cellule I/O est déclenchée par une première minuterie prédéfinie ou après avoir détecté un changement de tension par rapport à une tension nominale.

4. Procédé selon l'une quelconque des revendications 1 à 3, dans lequel la mesure d'une température de la IC est déclenchée par une seconde minuterie prédéfinie ou après avoir détecté un changement de température par rapport à une température nominale.

5. Procédé selon les revendications 2 à 4, dans lequel le code de compensation est égal à la somme du premier code de compensation élémentaire, du deuxième code de compensation élémentaire et du troisième code de compensation élémentaire.

6. Procédé selon l'une quelconque des revendications 1 à 5, dans lequel la mesure d'une tension de sortie de la cellule I/O est effectuée par un Convertisseur Analogique-Numérique (ADC) (120).

7. Procédé selon l'une quelconque des revendications 1 à 6, dans lequel la mesure d'une température de la IC est effectuée par un capteur de température (110).

8. processeur (130) pour déterminer un code de compensation pour une cellule d'Entrée/Sortie, IO, (220, 230, 240, 250) d'une puce intégrée, IC, (300), la cellule IO comprenant sa propre alimentation électrique, le processeur comprenant :

   - une unité configurée pour obtenir un premier code de compensation élémentaire à partir d'une cellule de mémoire (140) associée à la IC, le premier code de compensation élémentaire tenant compte de variations de processus de la IC et étant basé, au moins, sur une information représentative de conditions de fonctionnement de Processus, Tension et Température, PVT, de la IC ;
   - une unité configurée pour mesurer une tension de sortie de la cellule I/O dans les conditions de fonctionnement PVT et déterminer un deuxième code de compensation élémentaire en fonction au moins de la tension de sortie mesurée en réponse à une variation des conditions de fonctionnement PVT, le deuxième code de compensation tenant compte de variations de tension de la cellule I/O ;
   - une unité configurée pour mesurer une température de la IC dans les conditions de fonctionnement PVT et déterminer un troisième code de compensation élémentaire en fonction au moins de la température mesurée en réponse à une variation des conditions de fonctionnement PVT, le troisième code de compensation tenant compte de variations de température de la IC ; et,
   - une unité configurée pour déterminer le code de compensation en fonction au moins du premier code de compensation élémentaire, du deuxième code de compensation élémentaire et du troisième code de compensation élémentaire.

9. Processeur selon la revendication 8, configuré en outre pour déterminer le premier code de compensation élémentaire en fonction de courants dépendants du processus précédemment mesurés à la sortie de la cellule I/O.

10. Processeur selon l'une quelconque des revendications 8 à 9, configuré en outre pour mesurer une tension de sortie de la cellule I/O en réponse au déclenchement d'une première minuterie prédéfinie ou après avoir détecté un changement de tension par rapport à une tension nominale.

11. Processeur selon l'une quelconque des revendications 8 à 10, configuré en outre pour mesurer une température de la IC en réponse au déclenchement d'une seconde minuterie prédéfinie ou après avoir détecté un changement de température par rapport à une température nominale.

**12.** Processeur selon les revendications 9 à 11, dans lequel le code de compensation est égal à la somme du premier code de compensation élémentaire, du deuxième code de compensation élémentaire et du troisième code de compensation élémentaire.

**13.** Processeur selon l'une quelconque des revendications 8 à 12, dans lequel un Convertisseur Analogique-Numérique (ADC) (120) mesure une tension d'entrée pour la cellule IO.

**14.** Processeur selon l'une quelconque des revendications 8 à 13, dans lequel un capteur de température (110) mesure une température de la IC.

FIG. 1

FIG. 2

EP 2 711 800 B1

FIG. 3

240

$V_{DD}$

244

242

241

From
Core

243

$V_{SS}$

FIG. 4

START

S200 — DETERMINING THE FIRST COMPENSATION CODE

S210 — IC TEMPERATURE HAS CHANGED ?

YES — S220 DETERMINING THE SECOND COMPENSATION CODE

NO

VDD VOLTAGE HAS CHANGED ?

S230

YES — DETERMINING THE THIRD COMPENSATION CODE

NO

S240

S250 — DETERMINING THE COMPENSATION CODE

END

13

**EP 2 711 800 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7138824 B
- US 20110029266 A